(19) **Europäisches Patentamt European Patent Office Office européen des brevets**

(11) **EP 4 764 567 A1**

(12) **EUROPEAN PATENT APPLICATION**
published in accordance with Art. 153(4) EPC

(43) Date of publication:
**24.06.2026 Bulletin 2026/26**

(21) Application number: **25808251.0**

(22) Date of filing: **23.05.2025**

(51) International Patent Classification (IPC):
**G01R 31/396** (2019.01)    **G01R 31/3835** (2019.01)
**G01R 31/389** (2019.01)    **G01R 31/36** (2020.01)
**G06F 17/18** (2006.01)    **G01R 23/16** (2006.01)
**G01R 31/374** (2019.01)    **G01R 19/00** (2006.01)
**G01R 19/165** (2006.01)

(52) Cooperative Patent Classification (CPC):
**G01R 19/00; G01R 19/165; G01R 23/16;**
**G01R 31/36; G01R 31/374; G01R 31/3835;**
**G01R 31/389; G01R 31/396; G06F 17/18;**
**Y02E 60/10**

(86) International application number:
**PCT/KR2025/007018**

(87) International publication number:
**WO 2025/244460 (27.11.2025 Gazette 2025/48)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **23.05.2024 KR 20240067308**
            **31.10.2024 KR 20240152286**

(71) Applicant: **LG Energy Solution, Ltd.**
**Seoul 07335 (KR)**

(72) Inventors:
• **LEE, Jeong Hwan**
  **Daejeon 34122 (KR)**
• **PARK, Jae Dong**
  **Daejeon 34122 (KR)**
• **CHEON, Jae Yeong**
  **Daejeon 34122 (KR)**

(74) Representative: **BCKIP Part mbB**
**Landsberger Straße 98**
**80339 München (DE)**

(54) **BATTERY DIAGNOSIS DEVICE AND METHOD**

(57)    An apparatus for diagnosing battery disclosed in this document includes a communication interface configured to receive battery data acquired by applying a current signal to a battery pack, and at least one processor configured to remove noise from the battery data to generate preprocessed data, apply a fast Fourier transform to the preprocessed data and acquire impedance data, and extract a feature value in which an influence of a sensing line is corrected from the impedance data and diagnose whether the battery pack is abnormal.

FIG.3

**Description**

## TECHNICAL FIELD

### Cross-reference to Related Applications

This application claims priority from Korean Patent Application Nos. 10-2024-0067308, filed on May 23, 2024, and 10-2024-0152286, filed on October 31, 2024, the disclosures of which are incorporated by reference herein.

### Technical Field

Embodiments disclosed in this document relate to an apparatus and method for diagnosing battery.

## BACKGROUND ART

Research and development on secondary batteries is being have been actively conducted recently. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. In addition, the scope of use of the lithium ion batteries has expanded to include a power source for electric vehicles, and the lithium ion batteries are attracting attention as a next-generation energy storage medium.

When a defect exists in these batteries, heat generation or firing may occur during charging/discharging and use, which may pose a safety risk, and thus research on a method of diagnosing batteries based on battery data is being conducted. In particular, in order to minimize an operation downtime of a battery-using device and ensure performance and safety, it is necessary to inspect a battery pack within a short period of time, but there is a problem in that related technology is absent.

## DISCLOSURE OF THE INVENTION

## TECHNICAL PROBLEM

An embodiment disclosed in this document provides an apparatus for diagnosing battery that can precisely analyze voltage behavior by applying a current signal to a battery pack to quickly evaluate a state of a battery.

The technical problems of this document are not limited to the technical problems mentioned above, and other technical problems that are not mentioned may be clearly understood by those skilled in the art from the descriptions below.

## TECHNICAL SOLUTION

An apparatus for diagnosing battery according to an embodiment includes a communication interface configured to receive battery data acquired by applying a current signal to a battery pack, and at least one processor configured to remove noise from the battery data to generate preprocessed data, apply a fast Fourier transform to the preprocessed data and acquire impedance data, and extract a feature value in which an influence of a sensing line is corrected from the impedance data and diagnose whether the battery pack is abnormal.

The at least one processor may be configured to derive an average voltage signal and an average current signal for a plurality of input signals included in the battery data, and apply the fast Fourier transform assuming that the average voltage signal and the average current signal are infinitely repeated.

The at least one processor may be configured to acquire the impedance data by dividing a voltage Fourier transform value derived through the fast Fourier transform by a current Fourier transform value.

The at least one processor may be configured to extract a difference between a first real number value and a second real number value included in the impedance data as a first feature value.

The at least one processor may be configured to derive a ratio of a frequency of a first imaginary number value and a frequency of a second imaginary number value included in the impedance data, and extract a value acquired by excluding a value acquired by multiplying the second imaginary number value by the ratio from the first imaginary number value as a second feature value.

The at least one processor may be configured to extract a sum of preset orders of the first feature value and the second feature value as a third feature value.

The at least one processor may be configured to diagnose whether the battery pack is abnormal by equally applying the weight to the feature value corresponding to the same battery module among a plurality of battery modules included in the battery pack or corresponding to the same sensing structure.

The at least one processor may be configured to diagnose whether the battery pack is abnormal by differently applying the weight to the feature value based on relative positions between the plurality of battery modules or relative positions of power lines connected to the plurality of battery modules and the battery pack.

The at least one processor may be configured to generate a trend line by removing an outlier based on a correlation between a voltage value included in the battery data and the feature value, and diagnose whether the battery pack is abnormal based on the trend line.

The at least one processor may be configured to derive a distance value between each battery cell included in the battery pack and the trend line, and diagnose a battery cell whose distance value is greater than or equal to a preset reference value as abnormal.

A method for diagnosing a battery according to an embodiment includes receiving battery data acquired by applying a current signal to a battery pack, removing noise from the battery data to generate preprocessed data, applying a fast Fourier transform to the preprocessed data and acquiring impedance data, and extracting a feature value in which an influence of a sensing line is compensated from the impedance data and diagnosing whether the battery pack is abnormal.

The applying of the fast Fourier transform may include deriving an average voltage signal and an average current signal for a plurality of input signals included in the battery data, and applying the fast Fourier transform assuming that the average voltage signal and the average current signal are infinitely repeated.

The acquiring of the impedance data may include acquiring the impedance data by dividing a voltage Fourier transform value derived through the fast Fourier transform by a current Fourier transform value.

The extracting of the feature value may include extracting a difference between a first real number value and a second real number value included in the impedance data as a first feature value.

The extracting of the feature value may include deriving a ratio of a frequency of a first imaginary number value and a frequency of a second imaginary number value included in the impedance data, and extracting a value acquired by excluding a value acquired by multiplying the second imaginary number value by the ratio from the first imaginary number value as a second feature value.

The extracting of the feature value may include extracting a sum of preset dimensions of the first feature value and the second feature value as a third feature value.

The diagnosing of whether the battery pack is abnormal may include diagnosing whether the battery pack is abnormal by equally applying the weight to the feature value corresponding to the same battery module among a plurality of battery modules included in the battery pack or corresponding to the same sensing structure.

The diagnosing of whether the battery pack is abnormal may include diagnosing whether the battery pack is abnormal by differently applying the weight to the feature value based on relative positions between the plurality of battery modules or relative positions of power lines connected to the plurality of battery modules and the battery pack.

The diagnosing of whether the battery pack is abnormal may include generating a trend line by removing an outlier based on a correlation between a voltage value included in the battery data and the feature value, and diagnosing whether the battery pack is abnormal based on the trend line.

The diagnosing of whether the battery pack is abnormal may include deriving a distance value between each battery cell included in the battery pack and the trend line, and diagnosing a battery cell whose distance value is greater than or equal to a preset reference value as abnormal.

## ADVANTAGEOUS EFFECTS

According to an apparatus for diagnosing battery according to an embodiment, the reliability of a battery system can be improved by quickly diagnosing the state of a battery and the efficiency can be increased by reducing the time related to battery diagnosis.

## BRIEF DESCRIPTION OF THE DRAWINGS

FIG. 1 is a block diagram showing a general battery system including an apparatus for diagnosing battery according to an embodiment.

FIG. 2 is a block diagram showing a configuration of an apparatus for diagnosing battery according to an embodiment.

FIG. 3 is a schematic diagram showing a flow of diagnosing a state of a battery by an apparatus for diagnosing battery according to an embodiment.

FIG. 4 is a diagram showing impedance data before error correction utilized in an apparatus for diagnosing battery according to an embodiment.

FIG. 5 is a diagram showing feature values before error correction utilized in an apparatus for diagnosing battery according to an embodiment.

FIG. 6 is a diagram showing other feature values before error correction utilized in an apparatus for diagnosing battery according to an embodiment.

FIG. 7 is a diagram showing a structure of a battery pack which is a diagnosis target of an apparatus for diagnosing battery according to an embodiment.

FIG. 8 is a diagram showing feature values included in a pulse graph utilized in an apparatus for diagnosing battery according to an embodiment.

FIG. 9 is a diagram showing an average graph for an applied signal utilized in an apparatus for diagnosing battery according to an embodiment.

FIG. 10 is a diagram showing a process of deriving a feature value by an apparatus for diagnosing battery according to an embodiment.

FIG. 11 illustrates feature values derived by an apparatus for diagnosing battery according to an embodiment.

FIG. 12 illustrates a control flowchart of a battery diagnosis method according to an embodiment.

FIG. 13 continues to illustrate a control flowchart of a battery diagnosis method according to an embodiment, following FIG. 12.

## MODE FOR CARRYING OUT THE INVENTION

Hereinafter, various embodiments disclosed in this document will be described in detail with reference to the accompanying drawings. In this document, the same reference numerals are used for the same components in the drawings, and duplicate descriptions of the same components are omitted.

For various embodiments disclosed in this document, specific structural or functional descriptions are provided only for the purpose of describing the embodiments, and the various embodiments disclosed in this document may be implemented in various forms and should not be construed as being limited to the embodiments described in this document.

The expressions "first," "second," "firstly," or "secondly" used in various embodiments may modify various components, regardless of order and/or importance, and do not limit the components. For example, without departing from the scope of the rights of the embodiments disclosed in this document, a first component may be renamed as a second component, and similarly, a second component may also be renamed as a first component.

The terms used in this document are used only to describe specific embodiments and may not be intended to limit the scope of other embodiments. The singular expression may include the plural expression unless the context clearly indicates otherwise.

All terms used herein, including technical or scientific terms, may have the same meaning as commonly understood by a person of ordinary skill in the art of the embodiments disclosed in this document. Terms defined in commonly used dictionaries may be interpreted as having the same or similar meaning in the context of the relevant technology, and shall not be interpreted in an ideal or overly formal sense unless explicitly defined in this document. In some cases, even if a term is defined in this document, it cannot be interpreted to exclude the embodiments disclosed in this document.

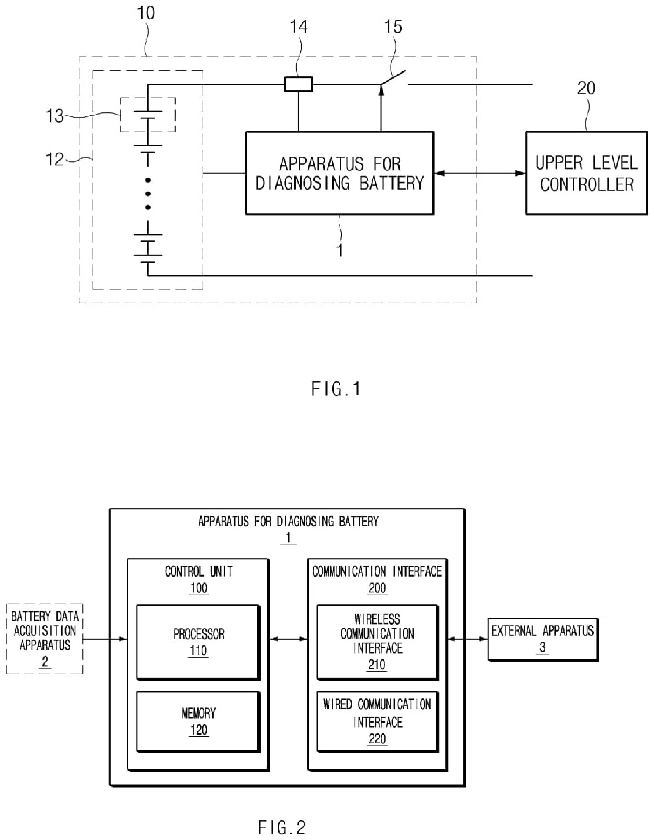

FIG. 1 is a block diagram showing a configuration of a general battery system including an apparatus for diagnosing battery according to various embodiments.

Specifically, FIG. 1 schematically illustrates a battery system 10 according to an embodiment disclosed in this document and an upper level controller 20 included in an upper level system.

As shown in FIG. 1, the battery system 10 may include a plurality of battery modules 12, a sensor unit 14, a switching unit 16, and an apparatus for diagnosing battery 1. In this case, the battery system 10 may be equipped with a plurality of battery modules 12, sensor units 14, switching units 16, and apparatus for diagnosing battery 1.

The plurality of battery modules 12 may include at least one battery cell 13 capable of being charged and discharged. The battery cell 13 may include a positive electrode, a positive electrode material, a negative electrode, a negative electrode material, a separator, an electrolyte, a polymer, and a case. In this case, the plurality of battery modules 12 may be connected in series or in parallel.

In addition, the battery system 10 may include a battery pack, the battery pack may be configured by combining multiple battery modules 12 and may include a battery management system (BMS) to monitor and control a battery state. In addition, the battery system 10 may include a battery bank, and the battery bank may configure an energy storage system by combining a plurality of battery packs.

The sensor unit 14 may include a current sensor, a voltage sensor, and a temperature sensor.

The current sensor may detect the current utilized in a process of determining the SOC of the battery cell 13.

The current sensor may measure the battery current flowing in the battery, that is, the charging current and the discharging current, and transmit a measurement result to the apparatus for diagnosing battery 1. According to an embodiment, the current sensor may measure the battery current at predetermined intervals during a charging cycle in which the battery is charged with power from an external apparatus 3 or a discharging cycle in which the battery is discharged, and transmit the measurement result to the apparatus for diagnosing battery 1.

The voltage sensor may be configured to be connected in parallel to the battery, detect the battery voltage, which is the voltage across both terminals of the battery, and generate a voltage signal representing the detected battery voltage.

The temperature sensor may be configured to measure the battery temperature and generate a temperature signal representing the measured battery temperature. The temperature sensor may be arranged in the case so as to measure a temperature close to an actual temperature of the battery. For example, the temperature sensor may be attached to a surface of at least one battery cell included in a cell group, and may detect a surface temperature of the battery cell as the battery temperature.

The switching unit 16 may be connected in series to a positive (+) terminal side or a negative (-) terminal side of the battery module 12 and may control the charge/discharge current flow of the battery module 12. For example, the switching unit 16 may use at least one relay, magnetic contactor, etc. depending on the specifications of the battery system 10.

The apparatus for diagnosing battery 1 may monitor the voltage, current, and temperature of the battery system 10 and control and manage the voltage, current, and temperature to prevent overcharge and overdischarge, and may include, for example, a battery management system (BMS).

The apparatus for diagnosing battery 1 is an interface for receiving various parameters, and may include a plurality of terminals and a circuit that is connected to these terminals and processes input values. In addition, the apparatus for diagnosing battery 1 may control the ON/OFF of the switching unit 16, for example, a relay or contactor, and may be connected to the battery module 12 and monitor the state of each battery module 12.

In addition, the apparatus for diagnosing battery 1 may receive current data, voltage data, and temperature data from the sensor unit 14 to acquire battery data, and diagnose the state of the battery.

The upper level controller 20 may transmit a control signal for controlling the battery module 12 to the apparatus for diagnosing battery 1. Accordingly, the operation of the apparatus for diagnosing battery 1 may be controlled based on the control signal received from the upper level controller 20. In addition, the battery module 12 may be a component included in an energy storage system (ESS). In this case, the upper level controller 20 may be a controller (BBMS) of a battery bank including a plurality of battery systems 10 or an ESS controller that controls the entire ESS including a plurality of battery banks. However, the battery system 10 is not limited to these uses.

FIG. 2 illustrates a block diagram showing the configuration of an apparatus for diagnosing battery according to an embodiment.

Referring to FIG. 2, the apparatus for diagnosing battery 1 according to an embodiment includes a control unit 100 including at least one processor 110 and a memory 120, and a communication interface 200, and may diagnose a battery by communicating with an external apparatus 3 through the communication interface 200 and transmit the diagnosis result to the outside.

According to an embodiment, the apparatus for diagnosing battery 1 may include a user terminal and/or a server device that can communicate with the external apparatus 3.

Specifically, when the apparatus for diagnosing battery 1 is a user terminal, the control unit 100 of the apparatus for diagnosing battery 1 may be configured as a CPU of the user terminal to enable on-device diagnosis of the battery by the user terminal. In this case, the user terminal may include, but is not limited to, a personal computer, a terminal, a portable telephone, a smart phone, a handheld device, a wearable device, etc.

In addition, when the apparatus for diagnosing battery 1 is a server device, the server device may be implemented as various computing devices such as a workstation, a cloud, a data drive, a data station, etc. The server device may be implemented as one or more server devices physically or logically separated based on functions, detailed configurations of functions, or data, etc., and may transmit and receive data through communication between the server devices and process the transmitted and received data.

The apparatus for diagnosing battery 1 according to an embodiment may mean any electronic device including the processor 110 and the memory 120, and may be mounted on and operated in a vehicle. Hereinafter, each component of the apparatus for diagnosing battery 1 will be described in detail.

A battery data acquisition apparatus 2 illustrated in FIG. 2 may include a data acquisition device as a separate physical configuration. Here, the data acquisition device may mean a device that monitors the state and performance of the battery in real time using sensors and measurement equipment, stores data, and acquires analysis data.

In addition, the battery data acquisition apparatus 2 may be a configuration that operates inside the apparatus for diagnosing battery. That is, the battery data acquisition apparatus 2 may operate as a hardware configuration inside the apparatus for diagnosing battery or may operate in the form of software to acquire battery data.

Here, the battery data acquisition apparatus 2 may include a constant current power supply for applying a constant current signal and a data acquisition device (DAQ).

The communication interface 200 may include a wireless communication interface 210 and a wired communication interface 220 to communicate with the external apparatus 3. The communication interface 200 may transmit and receive programs or various data for feature value calculation, class classification, and lifetime estimation of battery cells from a separately provided external server.

The wireless communication interface 210 may include at least one of a short-range communication module and a long-range communication module.

The short-range communication module may communicate with the external apparatus 3 adjacent to the apparatus for diagnosing battery 1 using a short-range communication method. Here, the short-range communication module may utilize one of the communication methods of Bluetooth, Bluetooth low energy, infrared data association (IrDA), Zigbee, Wi-Fi, Wi-Fi direct, ultra wideband (UWB), or near field communication (NFC).

The long-range communication module may include a communication module that performs various types of long-range communication, and may include a mobile communication interface. The mobile communication interface may transmit and receive wireless signals with at least one of a base station, an external terminal, and the external apparatus 3 on a mobile communication network. In addition, the long-range communication module may communicate with the external apparatus 3 or an external apparatus 3 such as another electronic device through a nearby access point (AP). The access point (AP) may connect the local area network (LAN) to which the apparatus for diagnosing battery 1 is connected to the wide area network (WAN) to which the communication server is connected. Accordingly, the apparatus for diagnosing battery 1 may be connected to the communication server through the wide area network (WAN) with the external apparatus 3 and communicate with each other.

The wired communication interface 220 may connect to a wired communication network and communicate with the external apparatus 3 through the wired communication network. For example, the wired communication interface 220 may connect to the wired communication network through Ethernet (IEEE 802.3 technology standard) or connect to the wired communication network through CAN communication and transmit and receive data with the external apparatus 3 through the wired communication network.

The apparatus for diagnosing battery 1 according to an embodiment may include an input/output interface (not shown). An interface that connects an input device (not shown) such as a keyboard, a mouse, or a touch panel, an output device (not shown) such as a display, and a processor 110 to allow data to be transmitted and received therebetween may be provided.

The memory 120 may store various information necessary for driving the apparatus for diagnosing battery 1. Specifically, the memory 120 may store an operating system and a program necessary for driving the apparatus for diagnosing battery 1, or may store data necessary for driving the apparatus for diagnosing battery 1. In addition, a learning model related to machine learning necessary for driving the apparatus for diagnosing battery 1 may be stored therein.

Specifically, the memory 120 may store various programs related to the calculation of feature values, class classification, and lifetime estimation of the battery cell. In addition, the memory 120 may store various data such as voltage, current, temperature, and feature value data of each battery cell.

In addition, the memory 120 may store a diagnosis result of the battery cell for which diagnosis was performed by the processor 110 and specific information of the battery cell.

The memory 120 may include a volatile memory 120 such as a static random access memory (S-RAM) and a dynamic random access memory (D-RAM) for temporarily storing data. In addition, the memory 120 may include a nonvolatile memory 120 such as a read only memory (ROM), an erasable programmable read only memory (EPROM), and an electrically erasable programmable read only memory (EEPROM) for storing data for a long period of time.

The processor 110 outputs a control signal to control the apparatus for diagnosing battery 1 as a whole. The processor 110 may include a single or a plurality of central processing units (CPUs) and graphics processing units (GPUs). In this case, the processor 110 may be implemented as an array of a plurality of logic gates, or may be implemented as a combination of a general-purpose microprocessor 110 and a memory 120 storing a program that can be executed on the microprocessor 110.

Specifically, the processor 110 may remove noise from battery data to generate preprocessed data, and the process of removing noise may include a process of correcting an error that occurs based on a physical structure of the battery pack.

In addition, the processor 110 may apply a fast Fourier transform to the preprocessed data to acquire impedance data. A fast Fourier transform may mean a process of converting a signal from a time domain to a frequency domain, and may mean an algorithm that quickly computes a Fourier transform by repeatedly splitting an input signal in half in a Fourier transform that converts a continuous signal from its original domain to a frequency domain to acquire the amplitude and phase of each frequency component.

In addition, the processor 110 may diagnose whether the battery pack is abnormal by extracting a feature value in which the influence of the sensing line is corrected from the impedance data.

Specifically, the sensing line is a wiring that is placed to fit the structure of the battery cell, battery module, and battery pack when designing the battery pack, and may be provided between the battery cell and the battery management device to perform the role of transmitting battery data. Accordingly, the sensing line may be provided in the battery pack in consideration of the length, the path, the protection device, etc. of the wiring so as to achieve the best performance according to the purpose and use of the battery system.

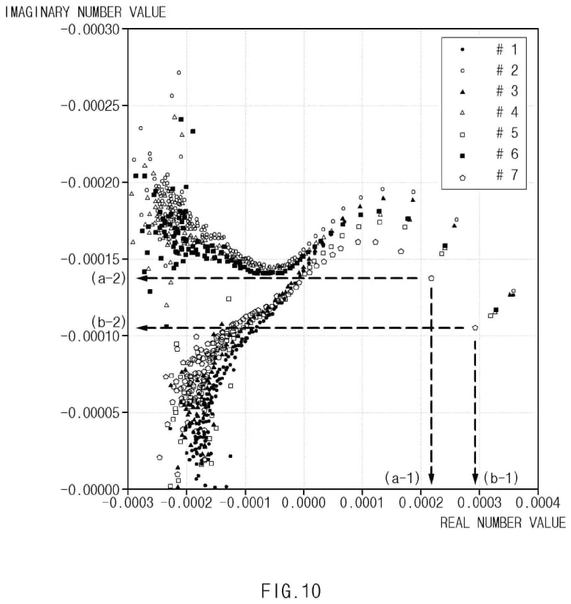

The processor 110 may correct the influence of the sensing line in the process of extracting the feature value in order to remove the influence of the sensing line in the diagnosis process, and specifically, the processor 110 may correct the influence of the sensing line by a method of removing the inductance component based on a ratio of a plurality of frequencies extracted from the impedance data. This will be described in detail below with reference to FIG. 10 and subsequent drawings.

In addition, the processor 110 may diagnose whether the battery pack is abnormal by applying a weight determined based on the structure of the battery pack to the feature value. Here, the weight may mean a value for correcting an error that occurs depending on the structure and location of the battery pack.

That is, the processor 110 may apply the same weight to battery data that is included in the same battery module or is the same sensing structure, and may apply different weights to battery data that is included in a different battery module or is a different sensing structure.

According to this, the processor 110 may correct an error that occurs due to a difference in the location of the battery module or a difference in the sensing structure, not due to the degradation or chemical properties of the battery.

In addition, the processor 110 may generate a trend line by removing an outlier based on the correlation between the voltage value included in the battery data and the feature value, and may diagnose whether the battery pack is abnormal based on a distance from the trend line.

Hereinafter, the diagnosis of whether the battery pack is abnormal will be described by analyzing the correlation between the voltage value and the feature value, but various embodiments may be further included. For example, the processor 110 may analyze the correlation between the battery degradation level and the feature value, or may analyze the correlation between the internal resistance and the feature value.

As described above, the apparatus for diagnosing battery 1 according to an embodiment may correct the error caused according to the shape of the sensing line included in the battery pack, and may improve the accuracy of the diagnosis in consideration of the structure of the battery pack.

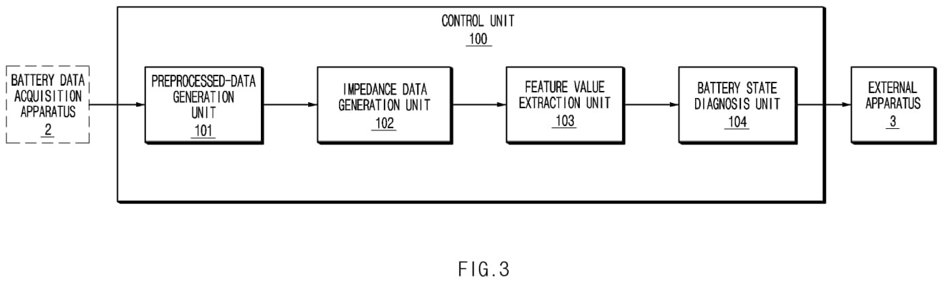

FIG. 3 schematically illustrates a flow in which an apparatus for diagnosing battery according to an embodiment determines a state of the battery. In FIG. 3, the configurations of 101 to 104 are implemented in the form of software blocks and may be stored in the memory 120 and executed by the processor 110.

Referring to FIG. 3, at least one processor 110 may receive battery data acquired by applying a current signal to a battery pack from the battery data acquisition apparatus 2 provided externally or included within the apparatus for diagnosing battery 1.

Here, the current signal applied to the battery pack may include a discharge current signal after charging, and the current signal may include a constant current signal (CC-signal). Specifically, the current signal applied to the battery pack may be applied as a single constant current signal or a repeated constant current signal in a situation where charging and discharging are repeated, may be applied as a single constant current signal or a repeated constant current signal in a situation where charging and resting are repeated, and may be applied as a single constant current signal or a repeated constant current signal in a situation where discharging and resting are repeated.

That is, the current signal applied to the battery pack may be a constant current signal suitable for dividing components for ease of analysis based on the fact that a voltage change pattern is different for each chemical reaction. In this case, an acquisition cycle of the battery data may be measured with a resolution of 1 mV or less and a measurement cycle of 10 ms or less, and may include various modified examples.

Thereafter, a preprocessed data generation unit 101 of the control unit 100 may generate preprocessed data by removing noise and the influence of the sensing line from the battery data.

Specifically, the processor 110 may generate preprocessed data by classifying the charging, discharging, and resting sections in accordance with synchronization between repeated or multiple applied signals, and according to this, the precision degradation due to the influence of voltage resolution of the battery data acquisition apparatus 2 may be alleviated, and noise may be removed.

In addition, the processor 110 may generate preprocessed data by removing the preset initial time from the charging or discharging one-time data, and according to this, the fast response characteristics of the battery cell in the current change section and the noise generated during the battery cell sensing process may be removed.

In addition, the processor 110 may filter noise at a certain time and frequency based on various filtering techniques to generate preprocessed data, and according to this, fundamental noise of mainly 50 Hz and 60 Hz and harmonic noise may be removed.

Thereafter, an impedance data generation unit 102 of the control unit 100 may acquire impedance data by applying a fast Fourier transform to the preprocessed data. Specifically, the processor 110 may derive an average voltage signal and an average current signal for a plurality of applied signals included in the battery data, and may apply a fast Fourier transform by assuming that the average voltage signal and the average current signal are infinitely repeated.

Thereafter, the processor 110 may acquire impedance data by dividing a voltage Fourier transform value derived through the fast Fourier transform by a current Fourier transform value.

A feature value extraction unit 103 of the control unit 100 may extract and correct a feature value by selecting a specific point in time from a graph where impedance data is expressed, or extract and correct an individual component based on an equation related to a chemical reaction.

In this case, the processor 110 may extract a feature value of a time zone when the influence of the sensing line is the smallest, and the time zone when the influence of the sensing line is the smallest may be acquired during the process of performing correction by the processor 110 or may include a preset time zone.

The processor 110 may extract a difference between a first real number value and a second real number value included in the impedance data as a first feature value, and extract a value, which is obtained by subtracting a value, which is obtained by multiplying a second imaginary number value of a different time point by a frequency ratio, from a first imaginary number value of a specific point in time, as a second feature value, and extract a sum of a preset order of the first feature value and the second feature value as a third feature value.

Thereafter, a battery state diagnosis unit of the processor 110 may diagnose whether the battery cell is abnormal based on the correlation between the extracted feature value and the voltage value.

Specifically, the processor 110 may remove an outlier that exhibit unusual behavior in the graph of the feature value and the resting voltage value before signal application, and the outlier may mean a data point that deviates into an abnormal category compared to other data points based on a visual or statistical method.

The processor 110 may generate a trend line for the group from which the outlier has been removed, calculate a distance value from the trend line for each battery cell, and diagnose a battery cell whose distance value from the trend line is greater than or equal to a reference value as an abnormal battery cell.

Thereafter, the processor 110 may transmit information about the battery cell diagnosed as abnormal or normal to the external apparatus 3 through the communication interface 200, and according to this, a user related to the battery may remotely check the diagnosis result of the battery cell.

In addition, the processor 110 may control the battery based on the diagnosis result. Specifically, if it is determined, as the diagnosis result, that the battery cell is normal, the processor 110 may maintain the current state. On the other hand, the processor 110 may protect the battery through control such as stopping charging/discharging, providing a warning notification, and activating the cooling system if it is determined, as the diagnosis result, that the battery cell is abnormal.

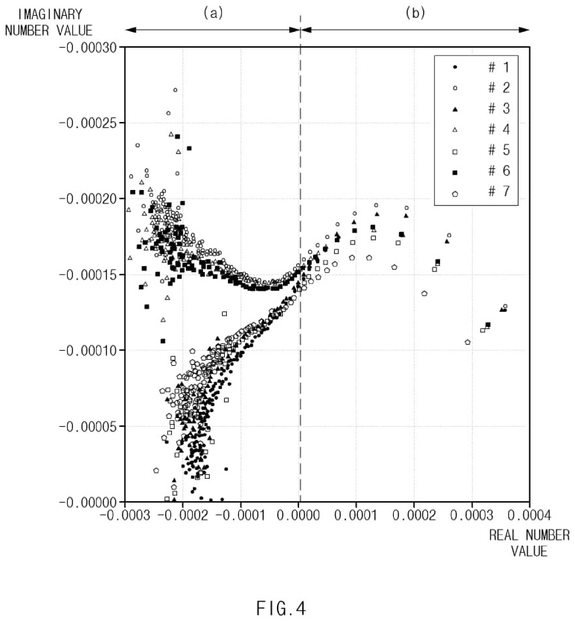

FIG. 4 illustrates an impedance graph before error correction utilized in an apparatus for diagnosing battery according to an embodiment.

Referring to FIG. 4, the processor 110 may process preprocessed data acquired by preprocessing battery data to acquire impedance data, and when electrochemical Nyquist analysis (Nyquist plot) is performed by applying electrochemical impedance spectroscopy (EIS) to the impedance data for the preprocessed data, the result may be expressed as in FIG. 4.

In this case, the horizontal axis of FIG. 4 may mean a real part of the impedance component, and the vertical axis may mean an imaginary part of the impedance component. In addition, each shape may mean a different battery cell, and the index on the right side of the graph may mean the number of the battery cell.

To this end, the processor 110 may apply a sine wave to a sample in sequence from high frequency to low frequency by utilizing impedance spectroscopy, measure a change in amplitude and phase according to a response sine wave coming through the sample, and then analyze the impedance. In this case, the processor 110 may derive an electrochemical Nyquist plot, which is a graph expressed as a complex number in which one coordinate is drawn for one frequency, as shown in FIG. 4.

Specifically, referring to area (a), it can be confirmed that the imaginary number values are divided into two groups from -0.0003 ohm to 0.0000 ohm, even though the processor 110 derived impedance data from a battery pack under the same conditions.

Such a separation phenomenon may be caused by the influence of the sensing line that senses the battery data, or may be caused by the mutual coupling phenomenon, for example, in which two or more electrical elements interact with each other by each other's electromagnetic fields and have an influence in a direction opposite to the expected effect.

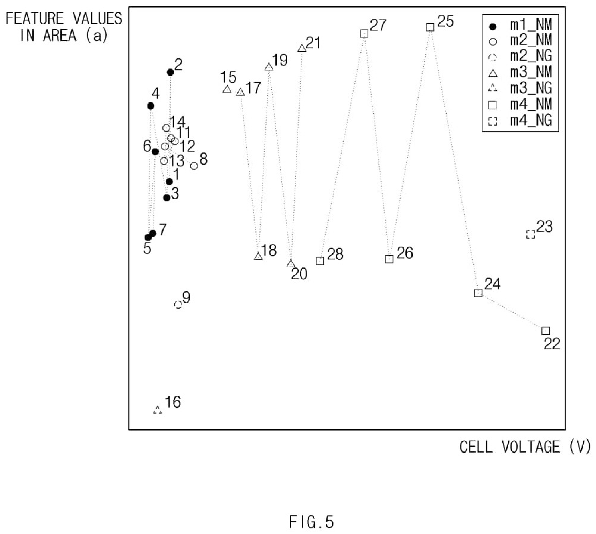

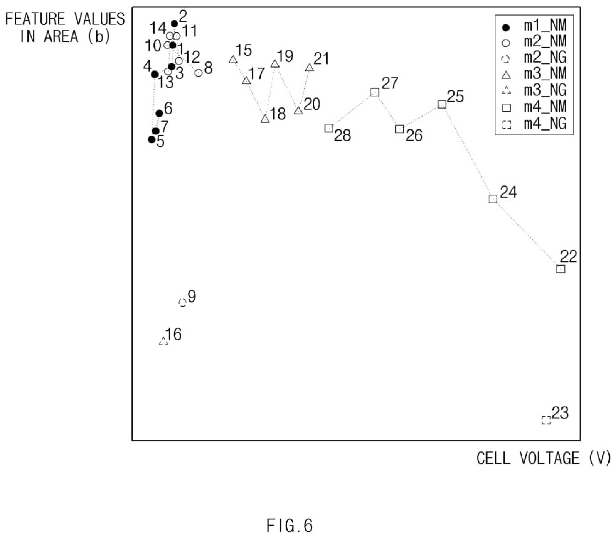

Specifically, the influence of the separation phenomenon on battery diagnosis will be described with reference to area (a) of FIG. 4 and FIG. 5 together, and area (b) of FIG. 4 and FIG. 6 together.

FIG. 5 illustrates feature values before error correction utilized in an apparatus for diagnosing battery according to an embodiment, and FIG. 6 illustrates other feature values before error correction utilized in the apparatus for diagnosing battery according to an embodiment.

First, referring to area (a) of FIG. 4 and FIG. 5 together, in area (a) of FIG. 4, the impedance values for respective battery cells can be displayed by dividing the battery cells into odd-numbered battery cells No. 1, No. 3, No. 5, and No. 7 and the rest cells No. 2, No. 4, and No. 6 due to the influence of the sensing line. In this way, if feature values are extracted from area (a) of FIG. 4, the feature values may be derived in a zigzag shape in the up and down directions, as shown in FIG. 5.

Continuing to refer to FIG. 5, NM in the index may mean a normal cell, NG may mean an abnormal cell, and m1 to m4 may mean the number of each battery module. In addition, the horizontal axis may mean the cell voltage in the resting state before the signal application, and the vertical axis may mean the feature value extracted from area (a) of FIG. 4.

In this way, when the influence of the sensing line is not corrected, the vertical positions of cells 28, 26, 24, and 22 corresponding to m4_NM (normal) and cell 23 corresponding to m4_NG (abnormal) may be similar in module 4, so that accurate diagnosis is likely to be hindered.

Similarly, referring to area (b) of FIG. 4 and FIG. 6 together, in area (b) of FIG. 4, the influence of the sensing line is reduced compared to area (a), so that the distinction of impedance values for respective battery cells can be displayed with a reduced degree of distinction. In this way, if the feature value is extracted from area (b) of FIG. 4, the feature values may be derived in a zigzag shape in the up and down directions in a reduced form compared to FIG. 5, as in FIG. 6.

Continuing with reference to FIG. 6, similar to FIG. 5, NM in the index may mean a normal cell, NG may mean an abnormal cell, and m1 to m4 may mean the number of each battery module. In addition, the horizontal axis may mean the cell voltage in the resting state before signal application, and the vertical axis may mean the feature value extracted from area (b) of FIG. 4.

In the case where the influence of the sensing line is reduced, the vertical positions of cells 28, 26, 24, and 22 corresponding to m4_NM (normal) and cell 23 corresponding to m4_NG (abnormal) in module 4 can be distinguished, so that the accuracy of the diagnosis can be improved.

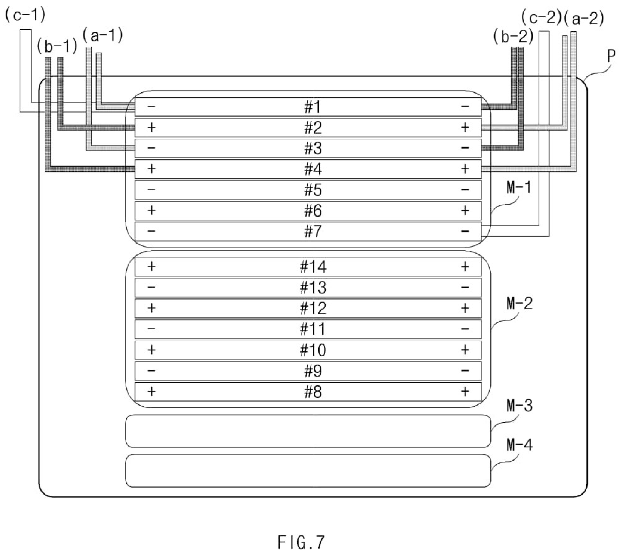

Based on this fact, the apparatus for diagnosing battery 1 according to an embodiment may correct the influence of the sensing line, and the specific correction principle and result will be described in detail below with reference to FIG. 7.

FIG. 7 is a diagram showing a structure of a battery pack, which is a diagnosis target of an apparatus for diagnosing battery according to an embodiment.

Referring to FIG. 7, an example of the structure of a battery pack P, battery modules M-1, M-2, M-3, and M-4, and battery cells #1 to #14 for which a diagnosis is performed by the apparatus for diagnosing battery 1 according to an embodiment is illustrated.

Specifically, the battery cells #1 to #14 may constitute the battery modules M-1 and M-2, and multiple battery modules M-1, M-2, M-3, and M-4 may constitute the battery pack P, each of sensing lines a-1, a-2, b-1, and b-2 may monitor a state of each cell, and power lines c-1 and c-2 may transmit power to the battery pack P.

In the case of the battery cells #1 to #7 included in the battery module M-1, the odd-numbered battery cells #1, #3, #5, and #7 and the even-numbered battery cells #2, #4, #6, and #8 may be sensed by different sensing lines.

In addition, since the battery cells #1 to #7 included in the battery module M-1 are influenced by different power lines c-1 and c-2 due to differences in their physical location and structure, differences may occur in acquired battery data acquired even under the same conditions.

In addition, heat distribution of each of the battery modules M-1, M-2, M-3, and M-4 may vary depending on its location, and the pressurized pressure may vary depending on the stacking method and structure. Accordingly, the voltage, internal resistance, and capacity of each of the battery modules M-1, M-2, M-3, and M-4 may vary, and accordingly, the processor 110 may correct a difference according to the position of the battery module by applying a weight to each battery data.

Specifically, the processor 110 may apply the same weight to the feature value corresponding to the same battery module or corresponding to the same sensing structure, and the processor 110 may apply different weights to the feature value based on the relative positions between the plurality of battery modules or the relative positions of the power lines connected to the plurality of battery modules and the battery pack.

That is, since the feature values extracted from the same battery module show similar behaviors, the processor 110 may assign the same weight to the feature values, and since the feature values extracted from different battery modules show different behaviors according to the location or structure of each battery module, the processor 110 may correct that by assigning different weights to the feature values.

In addition, the processor 110 may set weights when designing a battery system to correct electromagnetic influences on a plurality of sensing lines or power lines as in FIG. 7, and may utilize an algorithm or machine learning model for deriving an optimal weight.

Specifically, when the directions or paths of the sensing loop between the even-numbered and odd-numbered battery cells are different as in the exemplary structure of FIG. 7, mutual coupling patterns may occur in reverse, and thus, a tendency of being opposite to each other may be exhibited for a predetermined period of time immediately after a current change.

The apparatus for diagnosing battery 1 according to an embodiment can eliminate the influence of the sensing line by performing correction in the frequency ratio in the process of extracting feature values to correct the influence of the sensing line.

However, the battery structure of FIG. 7 is exemplary, and various structural variations may exist depending on the shape of the battery (e.g., square, cylindrical, pouch-shaped, etc.) and the product to which the battery is applied (e.g., an electric vehicle, an ESS, a robot, etc.). Therefore, there may be various variations in the method of correcting the influence of the sensing line, and the correcting may be performed in a manner equivalent to that of the apparatus for diagnosing battery 1 according to an embodiment.

Hereinafter, an embodiment of deriving a feature value utilized in the apparatus for diagnosing battery 1 according to an embodiment will be described.

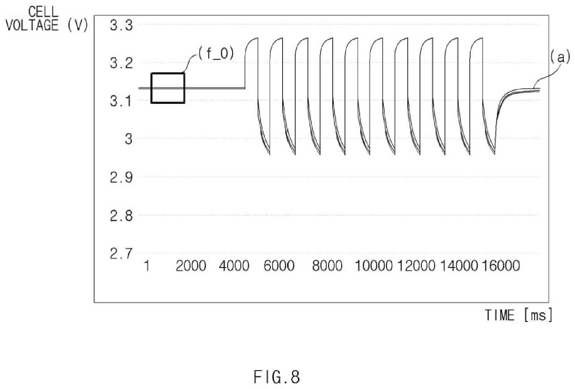

FIG. 8 illustrates feature values included in a pulse graph utilized in an apparatus for diagnosing battery according to an embodiment.

Specifically, the processor 110 may select an arbitrary point in time that may be utilized for analysis along with the feature value extracted from the impedance data in the pulse graph and utilize the value at that point in time as a feature value.

In this process, the processor 110 may select a feature value of a time zone with the least influence of the sensing line, and the process of selecting a feature value of a time zone with the least influence of the sensing line may be performed in parallel with the task of correcting the influence of the sensing line.

In this case, the horizontal axis of FIG. 8 may mean time [ms], and the vertical axis may mean cell voltage. In addition, each line (a) may mean a change in voltage acquired according to a pulse applied to the battery cell.

Specifically, the processor 110 may derive a cell voltage value of a resting period before pulse application as feature 0 (f_0). Specifically, the processor 110 may extract the cell voltage values of the resting period before the pulse application at reference intervals by a reference number of times and determine an average value of the extracted cell voltage values as feature 0 (f_0) .

For example, the processor 110 may extract 100 cell voltage values at 10 ms intervals during the resting period before the pulse application and determine the average value of the extracted 100 cell voltage values as feature 0 (f_0).

In particular, the processor 110 may generate a diagnosis index through correlation analysis between feature 0 (f_0), which is the cell voltage value of the resting period before the pulse application and other feature values, and may diagnose the battery by utilizing the generated diagnostic index.

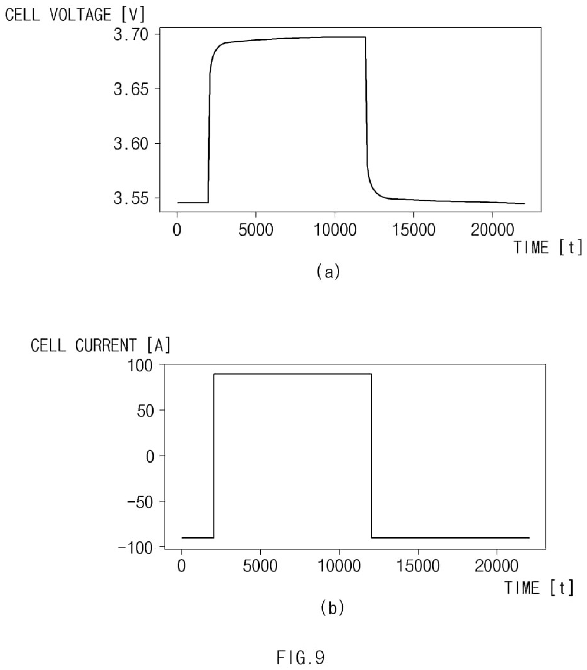

FIG. 9 illustrates an average graph for an applied signal utilized in an apparatus for diagnosing battery according to one embodiment.

Referring to FIG. 9, the processor 110 may acquire voltage data and current data by applying a plurality of signals to the battery pack. In this case, the acquired voltage data and current data include voltage data and current data acquired by directly applying the signal multiple times by the processor 110 or voltage data and current data acquired from a separate device.

Thereafter, the processor 110 may perform N measurements under the same conditions to collect M samples in each measurement, and may align and normalize the measured voltage and current data with the same criteria.

The processor 110 may derive one average voltage signal as in (a) of FIG. 9 and may derive one average current signal as in (b) of FIG. 9 by averaging N measurement data at each sample point.

Thereafter, the processor 110 may perform a fast Fourier transform assuming that the average voltage signal and average current signal derived from (a) and (b) of FIG. 9 are infinitely repeated. Accordingly, the effect of the Fourier transform may be maximized by processing the signal as a periodic signal in which the beginning and end are naturally connected.

The processor 110 may acquire impedance data according to Equation 1 below by dividing the voltage Fourier transform value acquired by performing the fast Fourier transform by the current Fourier transform value.

Impedance data (impedance) = voltage Fourier transform value (voltage_fft)/current Fourier transform value (current _fft)　　　[Equation 1]

FIG. 10 illustrates a process of deriving feature values by an apparatus for diagnosing battery according to an embodiment.

Referring to FIG. 10, the processor 110 may derive a feature value for determining whether a battery is abnormal from the electrochemical Nyquist plot of the impedance data acquired in FIG. 9.

Specifically, the processor 110 may extract a difference between a first real number value and a second real number value included in the impedance data as a first feature value. That is, in FIG. 10, the processor 110 may extract the difference between a real number value [1.5 Hz] at point (a-1) and a real number value [0.5 Hz] at point (b-1) as the first feature value.

In this case, since not all paths to the battery cell are the same due to the structure of the battery pack, there is a difference in the absolute resistance value, and thus the processor 110 may derive a relative difference in the real number value as feature value 1 to compensate for this difference.

In addition, the processor 110 may derive a ratio of the frequency of the first imaginary number value and the frequency of the second imaginary number value included in the impedance data, and extract a value which is acquired by subtracting a value, which is acquired by multiplying the second imaginary number value by the derived frequency ratio, from the first imaginary number value, as a second feature value.

In FIG. 10, the processor 110 may derive the second feature value based on a difference between an imaginary number value at point (a-2) and an imaginary number value at point (b-2), and in the case of the imaginary number value, mutual coupling may act on the sensing line, so that an inductance component jwL may be added. Accordingly, in order to compensate for the corresponding inductance component, the imaginary number value may be multiplied by the ratio of the high frequency and the low frequency to derive a difference value.

That is, the processor 110 may calculate a frequency ratio of the imaginary number value [1.5 Hz] at point (a-2) and the imaginary number value [0.5 Hz] at point (b-2) as 1.5 Hz/0.5 Hz and derive the frequency ratio as 3. The processor 110 may extract a difference value between by the imaginary number value [1.5 Hz] at point (a-2) and 3*imaginary number value [0.5 Hz], which is acquired by multiplying the imaginary number value [0.5 Hz] at point (b-2) by the frequency ratio, as the second feature value.

In addition, the processor 110 may extract the sum of squares of each of the first feature value and second feature value as a third feature value in order to comprehensively reflect information of the first feature value and second feature value. In this case, the processor 110 is not limited to the sum of squares, and may determine the sum of preset orders, such as the sum of cubes and the sum of fourth powers, as the third feature value.

Hereinafter, a process of diagnosing the battery using the feature value derived by the processor 110 will be described

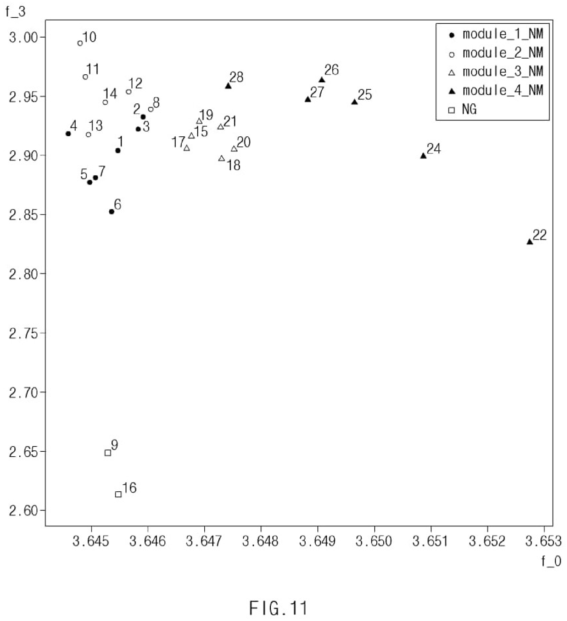

FIG. 11 illustrates feature values derived by an apparatus for diagnosing battery according to an embodiment.

Referring to FIG. 11, the horizontal axis may mean feature 0 (f_0) value, which may mean the cell voltage in the resting state before signal application, and the vertical axis may mean a third feature value (f_3) among the feature values selected by the processor 110.

In addition, in the index on the upper right of the graph, NM may mean a normal cell, NG may mean an abnormal cell, and module_1 to module_4 may mean the numbers of each battery module.

The graph illustrated in FIG. 11 is a result in which the influence of the sensing line is corrected, and thus the vertical positions of cells No. 28, No. 26, No. 24, and No. 22 corresponding to module_4_NM (normal) and cell No. 23 corresponding to NG (abnormal) in module 4, for which accurate diagnosis was difficult in FIG. 5, can be clearly distinguished.

The apparatus for diagnosing battery 1 according to an embodiment may diagnose whether the battery is abnormal even in the state of FIG. 11, but may improve the accuracy of the diagnosis by removing an outlier of a specific behavior based on the battery characteristics.

Specifically, the processor 110 may generate a trend line excluding the outlier, and derive a normal area based on a distance from the trend line. The processor 110 may determine a battery cell included in the normal area as a normal battery cell, and determine a battery cell detected outside the normal area as an abnormal battery cell.

Here, as for the method of removing the outlier by the processor 110, a statistical technique utilizing the mean, standard deviation, and interquartile range, or a machine learning technique utilizing the Isolation Forest, Local Outlier Factor (LOF), and One-Class Support Vector Machine (One-Class SVM), etc. may be utilized.

In this way, since the apparatus for diagnosing battery 1 according to an embodiment may grasp the trend of the normal range in the group in which the outlier of the specific behavior is removed from the entire battery cell, there is an effect of improving the accuracy of analysis.

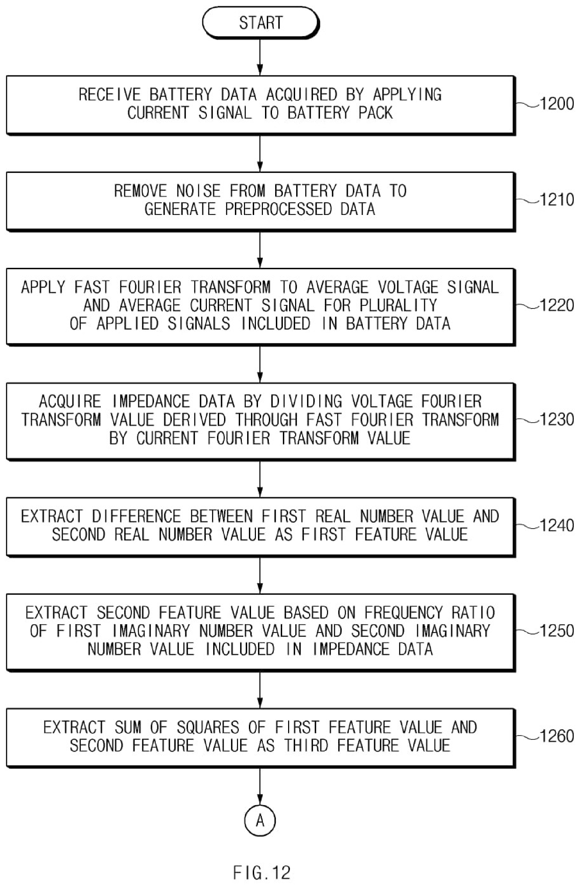

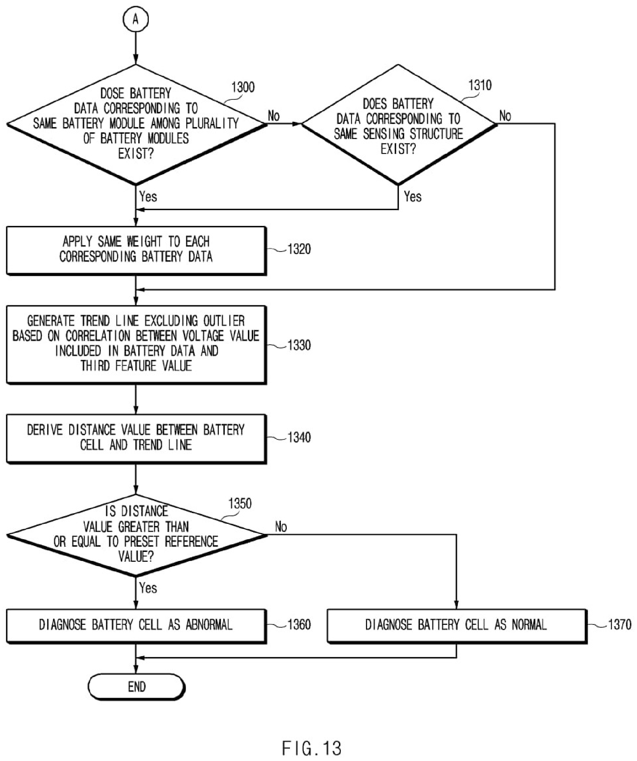

FIG. 12 illustrates a control flowchart of a battery diagnosis method according to an embodiment, and FIG. 13 continues to illustrate a control flowchart of the battery diagnosis method according to an embodiment, following FIG. 12.

Referring to FIG. 12, the processor 110 may receive battery data acquired by applying a current signal to the battery pack (1200). Here, the battery data acquired by applying the current signal may include all of the battery data acquired by applying the current signal to the battery pack by the processor 110, the battery data acquired by the external apparatus 3, and the battery data received by the server device.

Thereafter, the processor 110 may remove noise from the battery data to generate preprocessed data (1210). The processor 110 may apply a fast Fourier transform to an average voltage signal and an average current signal for the plurality of applied signals included in the battery data (1220).

Thereafter, the processor 110 may acquire impedance data by dividing a voltage Fourier transform value derived through the fast Fourier transform by a current Fourier transform value (1230), and may extract a plurality of feature values based on the impedance data.

Specifically, the processor 110 may extract a difference between a first real number value and a second real number value included in the impedance data as a first feature value (1240), extract a second feature value based on a frequency ratio of a first imaginary number value and a second imaginary number value included in the impedance data (1250), and extract a sum of squares of the first feature value and the second feature value as a third feature value (1260).

Subsequently, referring to FIG. 13, the processor 110 may determine whether battery data corresponding to the same battery module among the plurality of battery modules exists. That is, the processor 110 may determine whether battery data measured from a battery cell included in the same battery module exists (1300).

Thereafter, when battery data corresponding to the same battery module among the plurality of battery modules does not exist (NO in 1300), the processor 110 may determine whether battery data corresponding to the same sensing structure exists

(1310). That is, the processor 110 may determine whether battery data measured exists in a structure equally influenced by the sensing line and the power line.

When it is determined that battery data corresponding to the same battery module among a plurality of battery modules exists (YES in 1300) or battery data corresponding to the same sensing structure exists (YES in 1310), the processor 110 may apply the same weight to each corresponding battery data (1320).

Accordingly, a uniform battery diagnosis environment may be created by correcting deformation of battery data due to physical characteristics such as the location and structure of the battery module and deformation of battery data due to the sensing structure.

Thereafter, the processor 110 may generate a trend line excluding the outlier based on the correlation between the voltage value included in the battery data and a third feature value (1330), and the processor 110 may derive a distance value between the battery cell and the trend line (1340).

Here, the distance value between the battery cell and the trend line may mean the distance value between the location of the feature value measured from the battery cell and the trend line, and the processor 110 may utilize a distance measurement algorithm such as the Euclidean distance and Dijkstra algorithm to derive the distance value.

Thereafter, the processor 110 may determine whether the derived distance value between the battery cell and the trend line is greater than or equal to a preset reference value (1350).

The processor 110 may diagnose the corresponding battery cell as normal (1370) when it is determined that the distance value between the battery cell and the trend line is less than the preset reference value (NO in 1350), and may diagnose the corresponding battery cell as abnormal (1360) when it is determined that the distance value between the battery cell and the trend line exceeds the preset reference value (Yes in 1350).

In this way, in diagnosing an abnormality such as lithium deposition of a battery cell, the apparatus for diagnosing battery 1 according to an embodiment can remove the influence of the structure of the battery pack and diagnose the battery accurately and quickly according to various feature values, thereby achieving an effect of reducing the time required for battery diagnosis and reducing costs.

Meanwhile, the disclosed embodiments may be implemented in the form of a recording medium storing instructions executable by a computer. The instructions may be stored in the form of program code, which, when executed by a processor, may generate program modules to perform the operations of the disclosed embodiments. The recording medium may be implemented as a computer-readable recording medium.

The computer-readable recording medium includes all types of recording media storing instructions that can be decoded by a computer. For example, there may be read only memory (ROM), random access memory (RAM), magnetic tape, magnetic disk, flash memory, optical data storage, etc.

In addition, the computer-readable recording medium may be provided in the form of a non-transitory storage medium. Here, the 'non-transitory storage medium' means that it is a tangible device and does not contain signals (e.g., electromagnetic waves), and this term does not distinguish between cases where data is stored semi-permanently in the storage medium and cases where data is stored temporarily therein. For example, the 'non-transitory storage medium' may include a buffer in which data is temporarily stored.

According to an embodiment, the method according to various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or may be distributed online (e.g., downloaded or uploaded) through an application store (e.g., Play Store™) or directly between two user devices (e.g., smartphones). In the case of online distribution, at least a part of a computer program product (e.g., downloadable app) may be temporarily stored or temporarily generated in a machine-readable storage medium such as a memory of a manufacturer's server, an application store's server, a relay server.

In the above, even though all the components constituting the embodiments disclosed in this document have been described as being combined as one or operating in combination, the embodiments disclosed in this document are not necessarily limited to these embodiments. That is, within the scope of the purpose of the embodiments disclosed in this document, all of the components may be selectively combined and operated in combination with one or more of the components.

In addition, the terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and those skilled in the art to which the embodiments disclosed in this document belong may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

**Claims**

1. An apparatus for diagnosing battery, comprising:

   a communication interface configured to receive battery data acquired by applying a current signal to a battery pack; and
   at least one processor configured to remove noise from the battery data to generate preprocessed data, apply a fast Fourier transform to the preprocessed data and acquire impedance data, and extract a feature value in which an influence of a sensing line is corrected from the impedance data and diagnose whether the battery pack is abnormal.

2. The apparatus for diagnosing battery of claim 1, wherein the at least one processor is configured to derive an average voltage signal and an average current signal for a plurality of input signals included in the battery data, and apply the fast Fourier transform assuming that the average voltage signal and the average current signal are infinitely repeated.

3. The apparatus for diagnosing battery of claim 2, wherein the at least one processor is configured to acquire the impedance data by dividing a voltage Fourier transform value derived through the fast Fourier transform by a current Fourier transform value.

4. The apparatus for diagnosing battery of claim 1, wherein the at least one processor is configured to extract a difference between a first real number value and a second real number value included in the impedance data as a first feature value.

5. The apparatus for diagnosing battery of claim 4, wherein the at least one processor is configured to derive a ratio of a frequency of a first imaginary number value and a frequency of a second imaginary number value included in the impedance data, and extract a value acquired by excluding a value acquired by multiplying the second imaginary number value by the ratio from the first imaginary number value as a second feature value.

6. The apparatus for diagnosing battery of claim 5, wherein the at least one processor is configured to extract a sum of preset orders of the first feature value and the second feature value as a third feature value.

7. The apparatus for diagnosing battery of claim 1, wherein the at least one processor is configured to diagnose whether the battery pack is abnormal by equally applying the weight to the feature value corresponding to the same battery module among a plurality of battery modules included in the battery pack or corresponding to the same sensing structure.

8. The apparatus for diagnosing battery of claim 7, wherein the at least one processor is configured to diagnose whether the battery pack is abnormal by differently applying the weight to the feature value based on relative positions between the plurality of battery modules or relative positions of power lines connected to the plurality of battery modules and the battery pack.

9. The apparatus for diagnosing battery of claim 1, wherein the at least one processor is configured to generate a trend line by removing an outlier based on a correlation between a voltage value included in the battery data and the feature value, and diagnose whether the battery pack is abnormal based on the trend line.

10. The apparatus for diagnosing battery of claim 9, wherein the at least one processor is configured to derive a distance value between each battery cell included in the battery pack and the trend line, and diagnose a battery cell whose distance value is greater than or equal to a preset reference value as abnormal.

11. A method of diagnosing a battery, comprising:

receiving battery data acquired by applying a current signal to a battery pack;
removing noise from the battery data to generate preprocessed data;
applying a fast Fourier transform to the preprocessed data and acquiring impedance data; and
extracting a feature value in which an influence of a sensing line is compensated from the impedance data and diagnosing whether the battery pack is abnormal.

12. The method of claim 11, wherein the applying of the fast Fourier transform includes deriving an average voltage signal and an average current signal for a plurality of input signals included in the battery data, and applying the fast Fourier transform assuming that the average voltage signal and the average current signal are infinitely repeated.

13. The method of claim 12, wherein the acquiring of the impedance data includes acquiring the impedance data by dividing a voltage Fourier transform value derived through the fast Fourier transform by a current Fourier transform value.

14. The method of claim 13, wherein the extracting of the feature value includes extracting a difference between a first real number value and a second real number value included in the impedance data as a first feature value.

15. The method of claim 14, wherein the extracting of the feature value includes deriving a ratio of a frequency of a first imaginary number value and a frequency of a second imaginary number value included in the impedance data, and extracting a value acquired by excluding a value acquired by multiplying the second imaginary number value by the ratio from the first imaginary number value as a second feature value.

16. The method of claim 15, wherein the extracting of the feature value includes extracting a sum of preset orders of the first feature value and the second feature value as a third feature value.

17. The method of claim 16, wherein the diagnosing of whether the battery pack is abnormal includes diagnosing whether the battery pack is abnormal by equally applying the weight to the feature value corresponding to the same battery module among a plurality of battery modules included in the battery pack or corresponding to the same sensing structure.

18. The method of claim 17, wherein the diagnosing of whether the battery pack is abnormal includes diagnosing whether the battery pack is abnormal by differently applying the weight to the feature value based on relative positions between the plurality of battery modules or relative positions of power lines connected to the plurality of battery modules and the battery pack.

19. The method of claim 11, wherein the diagnosing of whether the battery pack is abnormal includes generating a trend line by removing an outlier based on a correlation between a voltage value included in the battery data and the feature value, and diagnosing whether the battery pack is abnormal based on the trend line.

20. The method of claim 19, wherein the diagnosing of whether the battery pack is abnormal includes deriving a distance value between each battery cell included in the battery pack and the trend line, and diagnosing a battery cell whose distance value is greater than or equal to a preset reference value as abnormal.

EP 4 764 567 A1

FIG.1

FIG.2

CONTROL UNIT
100

| BATTERY DATA ACQUISITION APPARATUS 2 | → | PREPROCESSED-DATA GENERATION UNIT 101 | → | IMPEDANCE DATA GENERATION UNIT 102 | → | FEATURE VALUE EXTRACTION UNIT 103 | → | BATTERY STATE DIAGNOSIS UNIT 104 | → | EXTERNAL APPARATUS 3 |

FIG.3

FIG.4

FEATURE VALUES
IN AREA (a)

CELL VOLTAGE (V)

FIG.5

FIG.6

FIG.7

FIG.8

(a)

(b)

FIG.9

FIG.10

FIG.11

START

RECEIVE BATTERY DATA ACQUIRED BY APPLYING CURRENT SIGNAL TO BATTERY PACK — 1200

REMOVE NOISE FROM BATTERY DATA TO GENERATE PREPROCESSED DATA — 1210

APPLY FAST FOURIER TRANSFORM TO AVERAGE VOLTAGE SIGNAL AND AVERAGE CURRENT SIGNAL FOR PLURALITY OF APPLIED SIGNALS INCLUDED IN BATTERY DATA — 1220

ACQUIRE IMPEDANCE DATA BY DIVIDING VOLTAGE FOURIER TRANSFORM VALUE DERIVED THROUGH FAST FOURIER TRANSFORM BY CURRENT FOURIER TRANSFORM VALUE — 1230

EXTRACT DIFFERENCE BETWEEN FIRST REAL NUMBER VALUE AND SECOND REAL NUMBER VALUE AS FIRST FEATURE VALUE — 1240

EXTRACT SECOND FEATURE VALUE BASED ON FREQUENCY RATIO OF FIRST IMAGINARY NUMBER VALUE AND SECOND IMAGINARY NUMBER VALUE INCLUDED IN IMPEDANCE DATA — 1250

EXTRACT SUM OF SQUARES OF FIRST FEATURE VALUE AND SECOND FEATURE VALUE AS THIRD FEATURE VALUE — 1260

A

FIG.12

A

DOSE BATTERY
DATA CORRESPONDING TO
SAME BATTERY MODULE AMONG PLURALITY
OF BATTERY MODULES
EXIST? ∼1300

No →

DOES BATTERY
DATA CORRESPONDING TO
SAME SENSING STRUCTURE
EXIST? ∼1310

No →

Yes ↓

Yes ↓

APPLY SAME WEIGHT TO EACH
CORRESPONDING BATTERY DATA ∼1320

GENERATE TREND LINE EXCLUDING OUTLIER
BASED ON CORRELATION BETWEEN VOLTAGE VALUE
INCLUDED IN BATTERY DATA AND
THIRD FEATURE VALUE ∼1330

DERIVE DISTANCE VALUE BETWEEN BATTERY
CELL AND TREND LINE ∼1340

IS DISTANCE
VALUE GREATER THAN
OR EQUAL TO PRESET REFERENCE
VALUE? ∼1350

No →

Yes ↓

DIAGNOSE BATTERY CELL AS ABNORMAL ∼1360

DIAGNOSE BATTERY CELL AS NORMAL ∼1370

END

FIG.13

## INTERNATIONAL SEARCH REPORT

| | International application No. |
|---|---|
| | **PCT/KR2025/007018** |

| | |
|---|---|
| **A.** | **CLASSIFICATION OF SUBJECT MATTER** |

**G01R 31/396**(2019.01)i; **G01R 31/3835**(2019.01)i; **G01R 31/389**(2019.01)i; **G01R 31/36**(2006.01)i; **G06F 17/18**(2006.01)i; **G01R 23/16**(2006.01)i; **G01R 31/374**(2019.01)i; **G01R 19/00**(2006.01)i; **G01R 19/165**(2006.01)i

According to International Patent Classification (IPC) or to both national classification and IPC

| | |
|---|---|
| **B.** | **FIELDS SEARCHED** |

Minimum documentation searched (classification system followed by classification symbols)

G01R 31/396(2019.01); G01N 27/02(2006.01); G01R 19/00(2006.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 전처리(preprocessing), 고속 푸리에 변환(Fast Fourier Transform), 센싱선(sensing line), 보정(compensation)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | JP 2022-007515 A (DENSO CORP.) 13 January 2022 (2022-01-13) paragraphs [0001], [0011]-[0019] | 1-4,7,8,11-14 |
| A | | 5,6,9,10,15-20 |
| Y | US 2016-0025815 A1 (GM GLOBAL TECHNOLOGY OPERATIONS LLC) 28 January 2016 (2016-01-28) paragraphs [0004], [0030] | 1-4,7,8,11-14 |
| Y | JP 2023-005756 A (DENSO CORP.) 18 January 2023 (2023-01-18) paragraph [0055] | 4,14 |
| A | JP 2002-525586 A (KEITH S. CHAMPLIN) 13 August 2002 (2002-08-13) paragraphs [0007]-[0059] | 1-20 |

| ✓ Further documents are listed in the continuation of Box C. | ✓ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 August 2025** | **20 August 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2025/007018**

### C. DOCUMENTS CONSIDERED TO BE RELEVANT

| Category* | Citation of document, with indication, where appropriate, of the relevant passages | Relevant to claim No. |
|---|---|---|
| A | JP 2019-138685 A (KEIHIN CORP.) 22 August 2019 (2019-08-22)<br>  paragraphs [0008]-[0026] | 1-20 |

## INTERNATIONAL SEARCH REPORT
### Information on patent family members

International application No.

**PCT/KR2025/007018**

| Patent document cited in search report | | | Publication date (day/month/year) | Patent family member(s) | | | Publication date (day/month/year) |
|---|---|---|---|---|---|---|---|
| JP | 2022-007515 | A | 13 January 2022 | US | 2023-0090001 | A1 | 23 March 2023 |
| | | | | WO | 2021-261239 | A1 | 30 December 2021 |
| US | 2016-0025815 | A1 | 28 January 2016 | CN | 105319506 | A | 10 February 2016 |
| | | | | CN | 105319506 | B | 19 February 2019 |
| | | | | DE | 102015111003 | A1 | 28 January 2016 |
| | | | | DE | 102015111003 | B4 | 16 November 2023 |
| | | | | US | 9857431 | B2 | 02 January 2018 |
| JP | 2023-005756 | A | 18 January 2023 | CN | 117597592 | A | 23 February 2024 |
| | | | | DE | 112022003290 | T5 | 18 April 2024 |
| | | | | JP | 7540403 | B2 | 27 August 2024 |
| | | | | US | 2024-0125863 | A1 | 18 April 2024 |
| | | | | WO | 2023-276577 | A1 | 05 January 2023 |
| JP | 2002-525586 | A | 13 August 2002 | AU | 1999-62456 | A1 | 03 April 2000 |
| | | | | AU | 2001-16563 | A1 | 12 June 2001 |
| | | | | CN | 100410678 | C | 13 August 2008 |
| | | | | CN | 1325551 | A | 05 December 2001 |
| | | | | CN | 1558253 | A | 29 December 2004 |
| | | | | EP | 1119882 | A1 | 01 August 2001 |
| | | | | EP | 1119882 | B1 | 25 November 2009 |
| | | | | US | 6002238 | A | 14 December 1999 |
| | | | | US | 6172483 | B1 | 09 January 2001 |
| | | | | US | 6262563 | B1 | 17 July 2001 |
| | | | | US | 6294896 | B1 | 25 September 2001 |
| | | | | WO | 00-16428 | A1 | 23 March 2000 |
| | | | | WO | 01-40810 | A1 | 07 June 2001 |
| JP | 2019-138685 | A | 22 August 2019 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240067308
- KR 1020240152286